# EUROPEAN PATENT APPLICATION

(11) **EP 2 530 559 A1**
(43) Date of publication of application: **05.12.2012**
(21) Application number: 10809218.0
(22) Date of filing: 19.03.2010
(51) Int. Cl.: G06F 3/041, G06F 3/044, G06F 1/24

(54) **TOUCH CONTROL SYSTEM FOR AUTOMATIC DETECTION AND RECOVERY AND RESETTING APPARATUS THEREOF**

(30) Priority: 29.01.2010 CN 201010110713
(71) Applicant: Tvm Corp., Taipei (TW)
(72) Inventor: CHIEN, Tawen, Taipei County (TW); HSIEH, Fufa, Kaohsiung (TW)
(74) Representative: Karakatsanis, Georgios
(86) International application number: PCT/CN2010/000337
(87) International publication number: WO 2011/091555

(57) **Abstract**

The present invention is directed to a reset apparatus adaptable to an automatic detection and recovery touch system, which primarily includes a state detector, a control signal generating circuit and a reset control circuit. The state detector detects the open or close state of a chassis that encloses a touch device, and then generates a state signal accordingly. The control signal generating circuit generates a control signal according to the state signal. The reset control circuit directs the touch device to reset according to the control signal. Accordingly, the touch device may perform resetting whenever the chassis changes state. Consequently, the touch device may search for new touch environment and then recover touch precision. The present invention also discloses an automatic detection and recovery touch system.

## Description

### BACKGROUND OF THE INVENTION

### 1. FIELD OF THE INVENTION

The present invention generally relates to a touch system, and more particularly to an automatic detection and recovery touch system and a reset apparatus thereof.

### 2. DESCRIPTION OF THE RELATED ART

In the application of some touch devices (e.g., capacitive touch devices), such as a touch game machine, the touch device along with a computer are often enclosed by a metal chassis to protect the computer from being invaded. The touch device usually includes a touch panel and a touch controller. When the touch panel becomes abnormal, the metal chassis need be opened and restart the power of the touch controller to reset the touch panel. However, it is observed that the sensing accuracy of the touch panel usually decreases greatly or the touch panel may not properly work after closing the metal chassis. The main reason is that the touch controller is reset when the metal chassis is opened. The surrounding environment will be affected, such as the change of the electrical field, after the metal chassis is closed. If the change amount of the electrical field of the touch panel goes beyond the automatic detection range of the touch controller, it may lead to a decrease in the sensing accuracy.

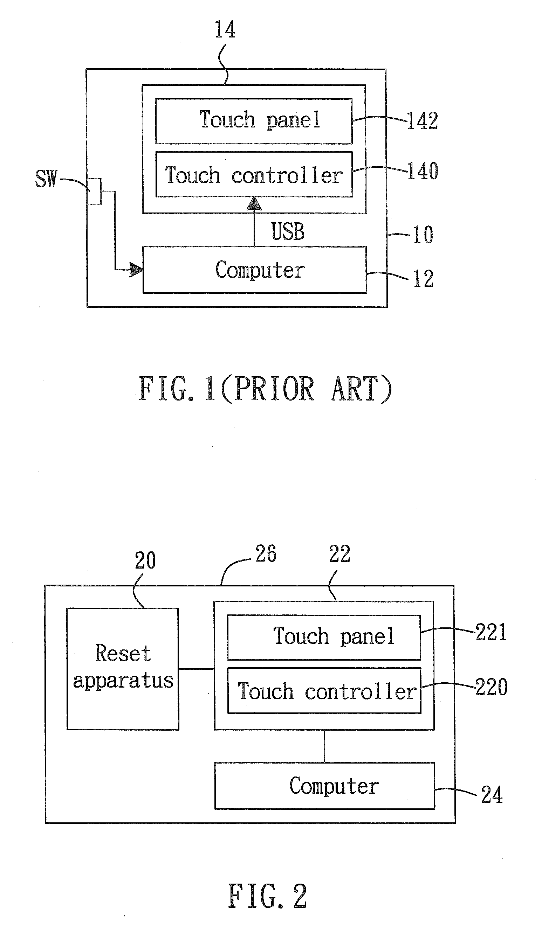

A software-based reset method as shown in FIG. 1 is usually used to overcome the above problem. When opening or closing the metal chassis 10, an associated state may be transmitted to the computer 12 via the switch SW. After processing by the control program of the computer 12, a signal is sent out to reset the touch controller 140 of the touch device 14, which includes the touch panel 142 and the touch controller 140, via a Universal Serial Bus (USB).

The conventional method discussed above performs resetting based on software, which need be rewritten with respect to different computer or operating system. The rewriting results in waste of resource and time.

Accordingly, a need has arisen to propose a novel mechanism for solving low accuracy problem due to opening and closing the chassis and for avoiding the incompatibility in computer software.

### SUMMARY OF THE INVENTION

In view of the foregoing, it is an object of the embodiment of the present invention to provide an automatic detection and recovery touch system and a reset apparatus thereof, which is adaptable to a variety of computers and is not restricted by distinct operating systems.

According to one embodiment, the reset apparatus of an automatic detection and recovery touch system comprises a state detector configured to detect an open or close state of a chassis and generate a state signal according to the open or close state, wherein a touch device is enclosed by the chassis; a control signal generating circuit configured to generate a control signal according to the state signal; and a reset control circuit configured to direct the touch device to reset according to the control signal; wherein the touch device performs resetting whenever the chassis changes state, and the touch device searches for new touch environment and then recovers touch precision.

In the reset apparatus, the chassis is a metal chassis.

In the reset apparatus, the touch device comprises a touch panel, which is a capacitive touch panel.

In the reset apparatus, the touch environment is electrical field environment surrounding the touch device.

In the reset apparatus, the state signal is an open state signal indicating that the chassis is in the open state, or the state signal is a close state signal indicating that the chassis is in the close state.

The reset apparatus further comprises a voltage divider configured to clamp the state signal to a default voltage value.

In the reset apparatus, the state detector is coupled to a chassis switch, when the chassis is opened or closed, the state detector generates a positive-edge state signal or a negative-edge state signal according to a changed state of the chassis switch.

In the reset apparatus, the control signal generating circuit comprises at least one edge-triggered one-shot circuit which generates a one-shot signal after receiving the state signal.

In the reset apparatus, the control signal generating circuit comprises a positive edge-triggered one-shot circuit and a negative edge-triggered one-shot circuit for receiving the positive-edge state signal and the negative-edge state signal respectively.

The reset apparatus further comprises a logic OR circuit coupled to outputs of the positive edge-triggered one-shot circuit and the negative edge-triggered one-shot circuit for passing the outputs through the logic OR gate.

In the reset apparatus, the reset control circuit comprises a power switch which is controlled by the control signal, when the control signal is active, the touch device is grounded via the power switch, when the control signal is passive, the touch device is provided power supply via the power switch to perform resetting.

In the reset apparatus, the reset control circuit comprises an invert buffer.

In the reset apparatus, the touch device comprises a touch panel and a touch controller, the reset control circuit controlling the touch panel or the touch controller.

In the reset apparatus, an output of the reset control circuit is coupled to and controls a reset input node of a touch controller of the touch device for performing resetting.

According to another embodiment, the automatic detection and recovery touch system includes a chassis, a touch device and a reset apparatus. The touch device is enclosed by the chassis which may be opened and closed. The reset apparatus includes a state detector, a control signal generating circuit and a reset control circuit. The state detector detects the open or close state of a chassis, and then generates a state signal accordingly. The control signal generating circuit generates a control signal according to the state signal. The reset control circuit directs the touch device to reset according to the control signal. Accordingly, the touch device may perform resetting whenever the chassis changes state. Consequently, the touch device may search for new touch environment and then recover touch precision.

In the system, the chassis is a metal chassis.

In the system, the touch device comprises a touch panel, which is a capacitive touch panel.

In the system, the touch environment is electrical field environment surrounding the touch device.

In the system, the state signal is an open state signal indicating that the chassis is in the open state, or the state signal is a close state signal indicating that the chassis is in the close state.

The system further comprises a voltage divider configured to clamp the state signal to a default voltage value.

In the system, the state detector is coupled to a chassis switch, when the chassis is opened or closed, the state detector generates a positive-edge state signal or a negative-edge state signal according to a changed state of the chassis switch.

In the system, the control signal generating circuit comprises at least one edge-triggered one-shot circuit which generates a one-shot signal after receiving the state signal.

In the system, the control signal generating circuit comprises a positive edge-triggered one-shot circuit and a negative edge-triggered one-shot circuit for receiving the positive-edge state signal and the negative-edge state signal respectively.

The system further comprises a logic OR circuit coupled to outputs of the positive edge-triggered one-shot circuit and the negative edge-triggered one-shot circuit for passing the outputs through the logic OR gate.

In the system, the reset control circuit comprises a power switch which is controlled by the control signal, when the control signal is active, the touch device is grounded via the power switch, when the control signal is passive, the touch device is provided power supply via the power switch to perform resetting.

In the system, the reset control circuit comprises an invert buffer.

In the system, the touch device comprises a touch panel and a touch controller, the reset control circuit controlling the touch panel or the touch controller.

In the system, an output of the reset control circuit is coupled to and controls a reset input node of a touch controller of the touch device for performing resetting.

Compared to the conventional technique, the automatic detection and recovery touch system and a reset apparatus of the present invention at least have the following advantages: the present invention may be adaptable to a variety of computers and not be restricted by distinct operating systems, may solve the problem due to opening and closing the chassis and may avoid the incompatibility in computer software.

Accordingly, the present invention is directed to a reset apparatus adaptable to an automatic detection and recovery touch system, which primarily includes a state detector, a control signal generating circuit and a reset control circuit. The state detector detects the open or close state of a chassis that encloses a touch device, and then generates a state signal accordingly. The control signal generating circuit generates a control signal according to the state signal. The reset control circuit directs the touch device to reset according to the control signal. Accordingly, the touch device may perform resetting whenever the chassis changes state. Consequently, the touch device may search for new touch environment and then recover touch precision. The present invention also discloses an automatic detection and recovery touch system

The technical means, objects, features and advantages of the present invention may be better appreciated with reference to the following embodiments and associated drawings.

### BRIEF DESCRIPTION OF THE DRAWINGS

FIG. 1 shows a traditional software reset method;
FIG. 2 shows a block diagram that illustrates an automatic detection and recovery touch system according to one embodiment of the present invention;
FIG. 3 is a schematic front view showing the touch system according to one embodiment of the present invention;
FIG. 4 shows a block diagram that illustrates a reset apparatus according to one embodiment of the present invention;
FIG. 5A shows a block diagram that exemplifies the reset apparatus;
FIG. 5B shows an exemplary detailed circuit diagram of the reset apparatus; and
FIG. 5C shows exemplary signal waveforms associated with FIG. 5A and FIG. 5B.

- 10: metal chassis
- 12: computer
- 14: touch device
- 140: touch controller
- 20: reset apparatus
- 200: state detector
- 202: control signal generating circuit
- 202A: positive edge-triggered one-shot circuit
- 202B: negative edge-triggered one-shot circuit
- 204: reset control circuit
- 22: touch device
- 220: touch controller
- 221: touch panel
- 142: touch panel
- 24: computer
- 26: chassis
- 260: hinge
- S: state signal
- C: control signal
- P: output of reset control circuit
- SW: switch
- SWm: chassis switch
- SWp: power switch
- R1-R6: resistor
- C1-C5: capacitor

- Q1: transistor
- D1-D2: diode

### DETAILED DESCRIPTION OF THE INVENTION

In order to demonstrate the technical means and function according to the object of the present invention, embodiments, structures, features and functions of an automatic detection and recovery touch system and a reset apparatus are discussed as follows.

Many aspects of the present structure and manufacture method can be better understood with reference to the drawings, which are not intended to limit the present invention.

FIG. 2 shows a block diagram that illustrates an automatic detection and recovery touch system according to one embodiment of the present invention, which includes a chassis 26, a touch device 22 and a reset apparatus 20. Specifically, the touch device 22 includes a touch panel 221 and a touch controller 220. The reset apparatus 20 is used to direct the touch device 22 to reset and the touch device 22 is enclosed by the chassis 26. Although the reset apparatus 20 and the computer 24 exemplified in FIG. 2 are disposed in the chassis 26, they may be disposed outside the chassis 26 according to another embodiment.

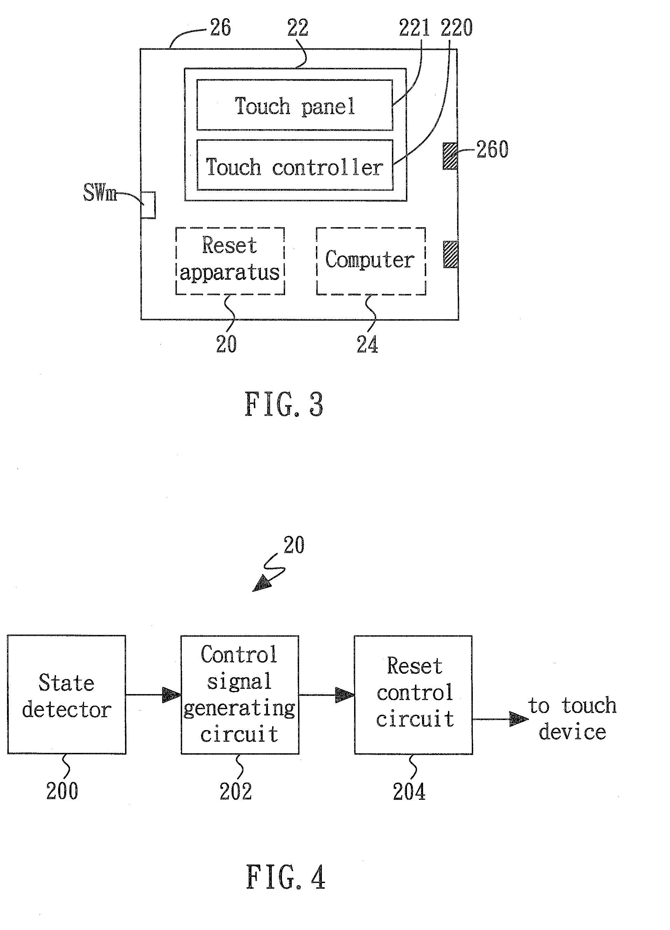

FIG. 3 is a schematic front view showing the touch system according to one embodiment of the present invention. Specifically, the front part (or front door) of the chassis 26 can be opened or closed on the hinge 260. A chassis switch SWm is disposed on the other side opposite to the hinge 260 (i.e. on the side that the front and back parts of the chassis 26 can be separated from or closed to each other). When the chassis 26 is opened or closed due to the chassis switch SWm, the surrounding environment of the touch panel 221 will be changed (such as the change of the electrical field), and such change may affect the touch precision of the touch panel 221. In the present embodiment, the touch panel 221 is a capacitive touch panel, and the chassis 26 is a metal chassis. In another embodiment, the touch panel 221 may be of other-type electrical field sensing, and the chassis 26 can be made of other materials.

FIG. 4 shows a block diagram that illustrates a reset apparatus 20 according to one embodiment of the present invention. The reset apparatus 20 primarily includes a state detector 200, a control signal generating circuit 202 and a reset control circuit 204. Specifically, the state detector 200 detects the open or close state of the chassis 26, for example, by detecting the state of the chassis switch SWm (FIG. 3), and then generates a state signal such as an open or close state signal accordingly. The control signal generating circuit 202 generates a control signal according to the state signal. For example, when receiving the open or close state signal, the control signal generating circuit 202 generates a corresponding control signal. Although the control signal generating circuit 202 generates the control signals according to the open and close state respectively in the present embodiment, it may generate only one control signal according to one state signal such as the close state signal in another embodiment. Afterwards, the reset control circuit 204 directs the touch device 22 to reset according to the control signal. For example, the reset control circuit 204 directs the touch controller 220 to reset. Consequently, whenever the chassis 26 changes its open/close state, the touch panel 221 may search for new touch environment according to the changed environment (e.g., the electrical field) and then recover touch precision.

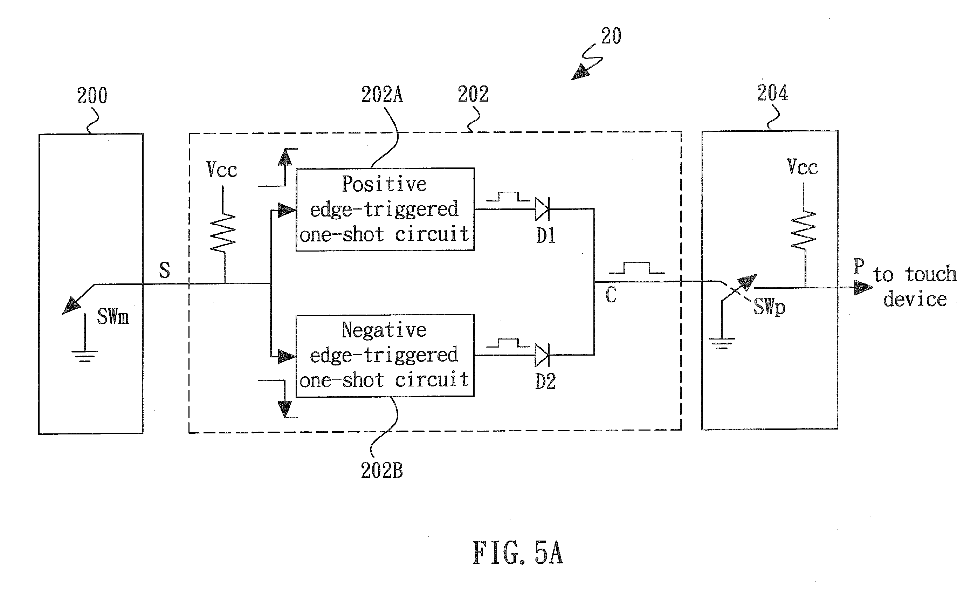

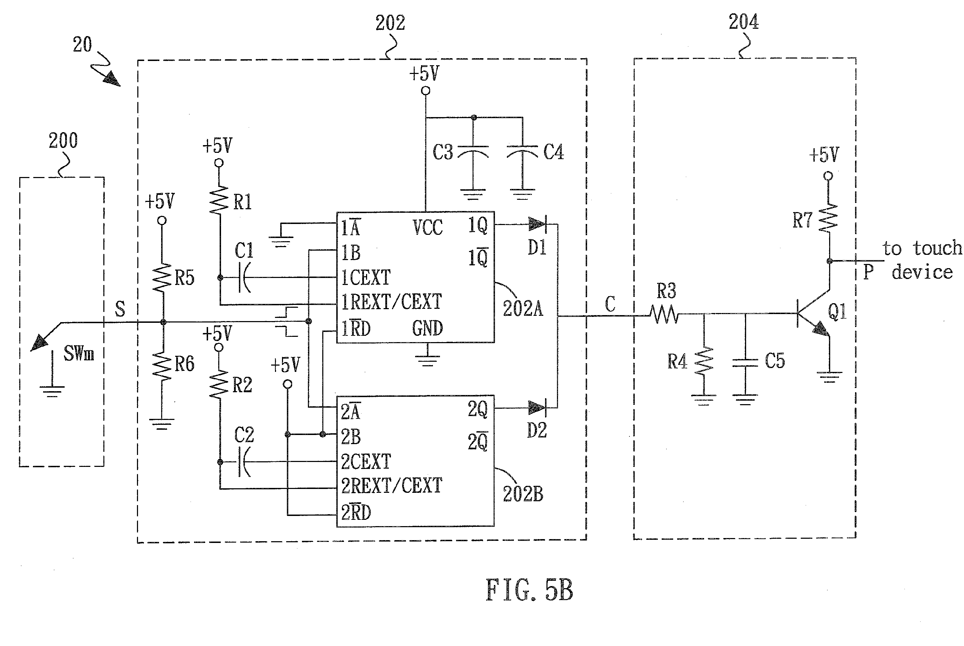

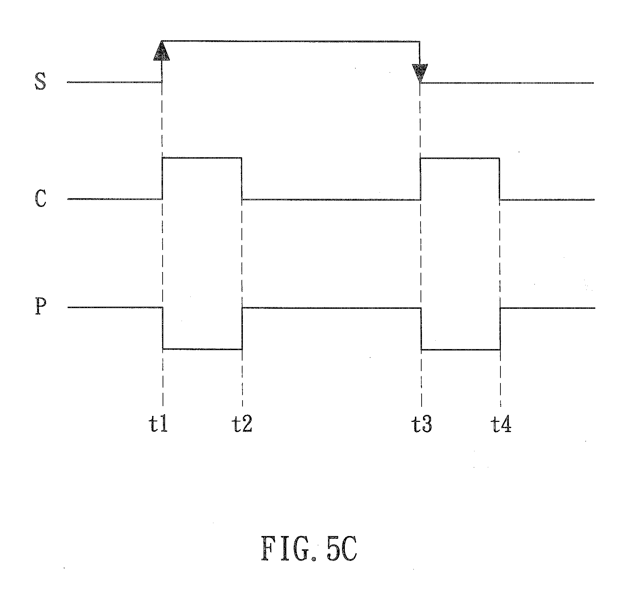

FIG. 5A shows a block diagram that exemplifies the reset apparatus 20, FIG. 5B shows an exemplary detailed circuit diagram of the reset apparatus 20, and FIG. 5C shows signal waveforms associated with FIG. 5A and FIG. 5B. In the embodiment, the state detector 200 is used to detect the chassis switch SWm. When the chassis 26 is closed, the chassis switch SWm is close, therefore generating a low-level (first-level) state signal S. On the contrary, when the chassis 26 is opened, the chassis switch SWm is open, therefore generating a high-level (second-level) state signal S. Accordingly, when the chassis 26 is from the close state to the open state, a positive-edge (or rising-edge) state signal S is generated; and when the chassis 26 is from the open state to the close state, a negative-edge (or falling-edge) state signal S is generated.

In the embodiment, the control signal generating circuit 202 includes at least one edge-triggered one-shot circuit (or a monostable oscillator) such as the positive edge-triggered one-shot circuit 202A and the negative edge-triggered one-shot circuit 202B shown in FIG. 5A. The dual retriggerable monostable multivibrators, model HD74HC123A, manufactured by HITACHI, may be used to implement the positive edge-triggered one-shot circuit 202A and the negative edge-triggered one-shot circuit 202B. The pulse width of the one-shot signal (i.e., the control signal C) generated by the positive edge-triggered one-shot circuit 202A can be determined by the resistor R1 and the capacitor C1. The pulse width of the one-shot signal generated by the negative edge-triggered one-shot circuit 202B can be determined by the resistor R2 and the capacitor C2. Besides, the capacitors C3 and C4 act as filtering capacitors for the power supply (+5V). Accordingly, when the input 1B of the positive edge-triggered one-shot circuit 202A receives the positive edge-triggered signal, its output 1Q generates the one-shot signal with the pulse width R1*C1. When the input 2A̅ of the negative edge-triggered one-shot circuit 202B receives the negative edge-triggered signal, its output 2Q generates the one-shot signal with the pulse width R2*C2. In the circuit shown in FIG. 5B, the diodes D1 and D2 are coupled with the outputs 1Q, 2Q of the positive and negative edge-triggered one-shot circuits 202A, 202B respectively to form a logic OR circuit. The outputs 1Q, 2Q of the positive or negative edge-triggered one-shot circuits 202A, 202B may pass through the logic OR circuit but cannot interfere with each other. Moreover, the voltage divider formed of the resistors R5, R6 in the control signal generating circuit 202 may clamp the state signal S to a proper or a default voltage value.

In the embodiment, the reset control circuit 204 includes a power switch SWp which is controlled by the control signal C. The output of the power supply SWp is coupled to the power input node of the touch controller 220. When the control signal C is active (e.g., at a high level), the power switch SWp will be close and its output may be connected to ground. When the control signal C is passive (e.g., at a low level), the power switch SWp will be open, therefore outputting the power Vcc. In other words, when opening or closing the chassis 26, the control signal C becomes active (e.g., generating the one-shot signal), which causes the touch device 22 grounded (i.e., power failure). After a predetermined time (e.g., the pulse width of the one-shot signal), the control signal C becomes passive, which causes the touch device 22 to receive the power Vcc and then perform resetting. Accordingly, the touch device 22 may search for new touch environment according to the changed environment (such as the change of electrical field). The resetting of the present invention may be implemented to control the power supply to the touch controller 220, the touch panel 221, or the whole touch device 22. In another embodiment, the output of the reset control circuit 204 is coupled to and controls a reset input node of the touch controller 220. In other words, the touch controller 220 performs resetting without power off.

In the circuit shown in FIG. 5B, the reset control circuit 204 includes an invert buffer which is composed of a transistor Q1, resistors R3, R4, R7 and a capacitor C5. Specifically, the emitter of the transistor Q1 is coupled to ground, the collector of the transistor Q1 acts as an output node and is coupled to the power supply (+5V) via the resistor R7, and the base of the transistor Q1 acts as an input node to receive the control signal C. When the control signal C is active (e.g., at a high level), the transistor Q1 is turned on, therefore grounding its output P. When the control signal C is passive (e.g., at a low level), the transistor Q1 is turned off, therefore pulling the output P to the power supply (+5V) via the resistor R7.

Please refer to FIG. 5C with respect to the system and circuits discussed above. When the chassis 26 is from the close state to the open state at time t1, the state detector 200 (e.g., a mechanic switch SWm) generates a positive-edge state signal S, which triggers the positive edge-triggered one-shot circuit 202A to generate an active pulse control signal C, thereby grounding the output P of the reset control circuit 204 to suspend power to the touch device 22. When the pulse of the control signal C stops at time t2, the reset control circuit 204 provides power supply (+5V) to the touch device 22 to perform resetting.

When the chassis 26 is from the open state to the close state at time t3, the state detector 200 generates a negative-edge state signal S, which triggers the negative edge-triggered one-shot circuit 202B to generate an active pulse control signal C, thereby grounding the output P of the reset control circuit 204 to suspend power to the touch device 22. When the pulse of the control signal C stops at time t4, the reset control circuit 204 provides power supply (+5V) to the touch device 22 to perform resetting. According to the above operations, the touch device 22 may perform resetting whenever the chassis changes state. Consequently, the touch device 22 may search for new touch environment and then recover touch precision.

Although specific embodiments have been illustrated and described, it will be appreciated by those skilled in the art that various modifications may be made without departing from the scope of the present invention, which is intended to be limited solely by the appended claims.

## Claims

1. A reset apparatus of an automatic detection and recovery touch system, comprising:
a state detector configured to detect an open or close state of a chassis and generate a state signal according to the open or close state, wherein a touch device is enclosed by the chassis;
a control signal generating circuit configured to generate a control signal according to the state signal; and
a reset control circuit configured to direct the touch device to reset according to the control signal;
wherein the touch device performs resetting whenever the chassis changes state, and the touch device searches for new touch environment and then recovers touch precision.

2. The reset apparatus of claim 1, wherein the chassis is a metal chassis.

3. The reset apparatus of claim 1, wherein the touch device comprises a touch panel, which is a capacitive touch panel.

4. The reset apparatus of claim 1, wherein the touch environment is electrical field environment surrounding the touch device.

5. The reset apparatus of claim 1, wherein the state signal is an open state signal indicating that the chassis is in the open state, or the state signal is a close state signal indicating that the chassis is in the close state.

6. The reset apparatus of claim 1, further comprising a voltage divider configured to clamp the state signal to a default voltage value.

7. The reset apparatus of claim 1, wherein the state detector is coupled to a chassis switch, when the chassis is opened or closed, the state detector generates a positive-edge state signal or a negative-edge state signal according to a changed state of the chassis switch.

8. The reset apparatus of claim 7, wherein the control signal generating circuit comprises at least one edge-triggered one-shot circuit which generates a one-shot signal after receiving the state signal.

9. The reset apparatus of claim 8, wherein the control signal generating circuit comprises a positive edge-triggered one-shot circuit and a negative edge-triggered one-shot circuit for receiving the positive-edge state signal and the negative-edge state signal respectively.

10. The reset apparatus of claim 9, further comprising a logic OR circuit coupled to outputs of the positive edge-triggered one-shot circuit and the negative edge-triggered one-shot circuit for passing the outputs through the logic OR gate.

11. The reset apparatus of claim 1, wherein the reset control circuit comprises a power switch which is controlled by the control signal, when the control signal is active, the touch device is grounded via the power switch, when the control signal is passive, the touch device is provided power supply via the power switch to perform resetting.

12. The reset apparatus of claim 11, wherein the reset control circuit comprises an invert buffer.

13. The reset apparatus of claim 11, wherein the touch device comprises a touch panel and a touch controller, the reset control circuit controlling the touch panel or the touch controller.

14. The reset apparatus of claim 1, wherein an output of the reset control circuit is coupled to and controls a reset input node of a touch controller of the touch device for performing resetting.

15. An automatic detection and recovery touch system, comprising:
a chassis which is capable of being opened or closed;
a touch device enclosed by the chassis;
a state detector configured to detect an open or close state of a chassis and generate a state signal according to the open or close state;
a control signal generating circuit configured to generate a control signal according to the state signal; and
a reset control circuit configured to direct the touch device to reset according to the control signal;
wherein the touch device performs resetting whenever the chassis changes state, and the touch device searches for new touch environment and then recovers touch precision.

16. The system of claim 15, wherein the chassis is a metal chassis.

17. The system of claim 15, wherein the touch device comprises a touch panel, which is a capacitive touch panel.

18. The system of claim 15, wherein the touch environment is electrical field environment surrounding the touch device.

19. The system of claim 15, wherein the state signal is an open state signal indicating that the chassis is in the open state, or the state signal is a close state signal indicating that the chassis is in the close state.

20. The system of claim 15, further comprising a voltage divider configured to clamp the state signal to a default voltage value.

21. The system of claim 15, wherein the state detector is coupled to a chassis switch, when the chassis is opened or closed, the state detector generates a positive-edge state signal or a negative-edge state signal according to a changed state of the chassis switch.

22. The system of claim 21, wherein the control signal generating circuit comprises at least one edge-triggered one-shot circuit which generates a one-shot signal after receiving the state signal.

23. The system of claim 22, wherein the control signal generating circuit comprises a positive edge-triggered one-shot circuit and a negative edge-triggered one-shot circuit for receiving the positive-edge state signal and the negative-edge state signal respectively.

24. The system of claim 23, further comprising a logic OR circuit coupled to outputs of the positive edge-triggered one-shot circuit and the negative edge-triggered one-shot circuit for passing the outputs through the logic OR gate.

25. The system of claim 15, wherein the reset control circuit comprises a power switch which is controlled by the control signal, when the control signal is active, the touch device is grounded via the power switch, when the control signal C is passive, the touch device is provided power supply via the power switch to perform resetting.

26. The system of claim 25, wherein the reset control circuit comprises an invert buffer.

27. The system of claim 25, wherein the touch device comprises a touch panel and a touch controller, the reset control circuit controlling the touch panel or the touch controller.

28. The system of claim 15, wherein an output of the reset control circuit is coupled to and controls a reset input node of a touch controller of the touch device for performing resetting.
